Europäisches Patentamt

European Patent Office

Office européen des brevets

(19)

(11) Numéro de publication : **0 168 313**
**B1**

(12) FASCICULE DE BREVET EUROPÉEN

(45) Date de publication du fascicule du brevet :
09.11.88

(51) Int. Cl.⁴ : **G 01 L 1/16**

(21) Numéro de dépôt : 85401299.4

(22) Date de dépôt : 27.06.85

(54) Transducteur piézoélectrique et capteur de pression utilisant un tel transducteur.

(30) Priorité : 13.07.84 FR 8411181

(43) Date de publication de la demande :
15.01.86 Bulletin 86/03

(45) Mention de la délivrance du brevet :
09.11.88 Bulletin 88/45

(84) Etats contractants désignés :
DE GB IT NL SE

(56) Documents cités :
DE-A- 3 223 801
US-A- 4 400 642
PATENTS ABSTRACTS OF JAPAN, vol. 6, no. 42 (E-98)[920], 16 mars 1982; & JP - A - 56 158491 (NIPPON TOKUSHU TOGYO K.K.) 07.12.1981

(73) Titulaire : THOMSON-CSF
173, Boulevard Haussmann
F-75379 Paris Cédex 08 (FR)

(72) Inventeur : Robin, Philippe
THOMSON-CSF SCPI 173, bld Haussmann
F-75379 Paris Cedex 08 (FR)
Inventeur : Micheron, François
THOMSON-CSF SCPI 173, bld Haussmann
F-75379 Paris Cedex 08 (FR)
Inventeur : Petit, Patrick
THOMSON-CSF SCPI 173, bld Haussmann
F-75379 Paris Cedex 08 (FR)
Inventeur : Broussoux, Dominique
THOMSON-CSF SCPI 173, bld Haussmann
F-75379 Paris Cedex 08 (FR)

(74) Mandataire : Lepercque, Jean et al
THOMSON-CSF SCPI 19, avenue de Messine
F-75008 Paris (FR)

## Description

La présente invention concerne un transducteur piézoélectrique ainsi qu'un capteur de pression utilisant un tel transducteur et permettant notamment de mesurer des valeurs de forces de pression, des valeurs de gradients de forces de pression ainsi que des flexions.

De nombreux matériaux présentent des propriétés piézoélectriques ou sont susceptibles de présenter de tels effets après un traitement approprié. Les matériaux piézoélectriques présentent également des propriétés pyroélectriques. On peut citer par exemple des céramiques ferroélectriques polarisés ou le quartz monocristallin. Plus récemment, sont apparus les polymères piézoélectriques. Ces derniers sont utilisés sous forme de films plans métallisés sur deux faces, qui ont été orientés mécaniquement ou non, et dans tous les cas polarisés par application d'un champ électrique intense (de l'ordre de 1 MV/cm), à température supérieure ou égale à la température ambiante. Grâce à ce traitement, les films en matériau polymère acquièrent des propriétés pyroélectrique et piézoélectrique permettant de les utiliser comme transducteurs. Comme application de ces films plans, on peut citer des capteurs de pression, de déplacements (microphone, hydrophone, jauge de contrainte, etc.) et de température (capteur pyroélectrique pour la détection d'intrus, pour l'imagerie infra-rouge).

Parmi les polymères utilisables à de telles fins, on peut citer à titre indicatif les polyfluorure de vinylidène ($PVF_2$), le polychlorure de vinyle (PVC), le polyfluorure de vinyle (PVF), ainsi que des copolymères par exemple de polytétrafluorure éthylène-polyfluorure de vinylydène ($PTFE-PVF_2$) et le polyfluorure de vinylidène-polytrifluoro éthylène $PVF_2-PTrFE$. Des films plans de ces polymères sont obtenus habituellement par extrusion-soufflage, calendrage, pressage ou évaporation de solvants.

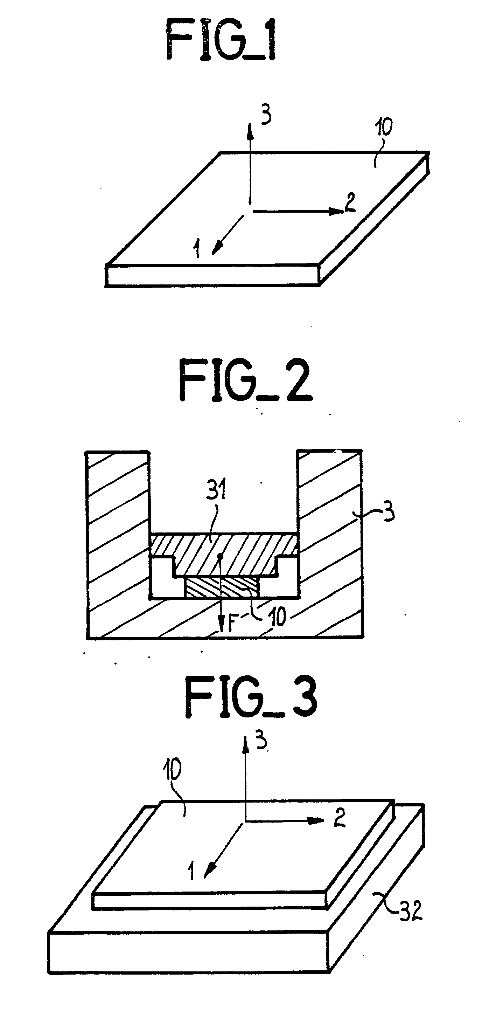

Le coefficient piézoélectrique hydrostatique $d_{3h}$ d'un matériau peut se décomposer en trois composantes. Par exemple, pour une lamelle de matériau piézoélectrique telle que représentée en figure 1, le coefficient piézoélectrique hydrostatique $d_{3h}$ du matériau se décompose en la somme de trois coefficients piézoélectriques uniaxiaux :

$$d_{3h} = d_{31} + d_{32} + d_{33}$$

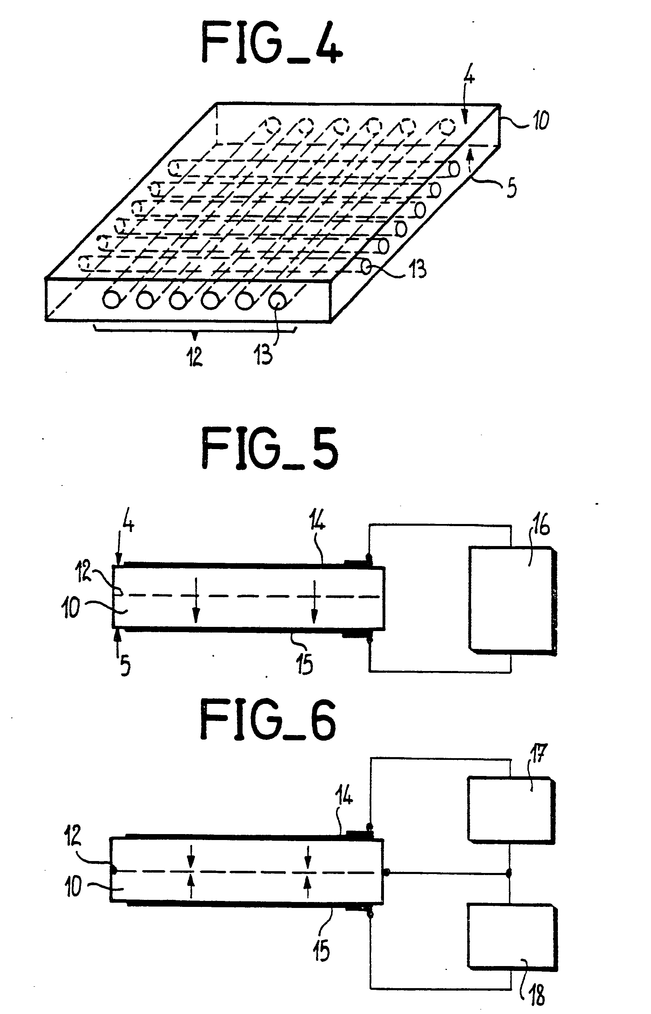

Il se trouve que dans de nombreux matériaux, et, en particulier dans un polyfluorure de vinylidène $PVF_2$ et ses copolymères, les signes des coefficients $d_{31}$ et $d_{32}$ sont inverses de celui de $d_{33}$. Il en résulte une valeur faible de $d_{3h}$. Afin de bénéficier d'une grande sensibilité aux sollicitations hydrostatiques, on est conduit, par exemple, à enfermer le matériau actif dans une enceinte étanche en acier et comportant un piston qui applique la pression de façon uniaxiale sur le matériau actif comme cela est représenté en figure 2.

Un film piézoélectrique 10 est placé dans une enceinte étanche 30, à plat au fond de cette enceinte. Un piston 31 coulisse dans l'enceinte 30 et permet d'appliquer une force de pression F à mesurer, sur le film piézoélectrique 10. Les mécanismes d'application F au piston 31 n'ont pas été représentés. Il apparaît néanmoins qu'une force F à appliquer au film piézoélectrique sera obligatoirement appliquée selon la direction de déplacement du piston 31.

Dans ce type de montage, on a :

$$d_{3h} = d_{33}$$

Cependant, cette solution présente l'inconvénient de nécessiter des montages précis en raison de la nécessité d'étanchéité du système ainsi que de la transmission sans perte des forces à mesurer et ne se prête pas à la réalisation de capteurs hydrostatiques de grandes dimensions.

Une telle solution est donc coûteuse.

Une autre solution, représentée en figure 3 consiste à coller le film piézoélectrique 10 sur un support rigide 32 présentant un très grand module d'YOUNG. Tout effort pouvant exister selon le plan du film 1 est donc contrarié par la rigidité du support 32.

Si $v$ est le coefficient de Poisson du matériau piézoélectrique, on obtient :

$$d_{3h} = [v/(1 - v)](d_{31} + d_{32}) + d_{33}$$

Comme $v = 0,3$ pour un polymère piézoélectrique, on a :
$d_{3h} \simeq 0,5 (d_{31} + d_{32}) + d_{33}$ ; ce qui est intéressant puisque $d_{31}$ et $d_{32}$ sont de signes contraires à $d_{33}$.

Cependant, cette dernière méthode ne convient pas à la fabrication de transducteurs de grandes dimensions, ni, ce qui revient au même, à une fabrication de petits transducteurs par découpe d'un transducteur de grandes dimensions.

C'est pourquoi l'invention propose un transducteur piézoélectrique fabriqué sous forme d'un film et présentant sur toute son étendue les mêmes caractéristiques.

L'invention concerne donc un transducteur piézoélectrique comportant un film en matériau piézoélectrique polarisé, comportant également au moins un matériau renforçant, incorporé dans la masse du film parallèlement aux faces principales du film, contrariant ainsi la déformation du film selon les directions parallèles à ces faces principales, caractérisé en ce qu'il comporte plusieurs matériaux renforçants disposés parallèlement et situés dans l'épaisseur du matériau piézoélectrique.

L'invention a également pour objet un capteur de pression utilisant un tel transducteur.

L'invention sera mieux comprise et d'autres avantages apparaîtront à la lecture de la description ci-après et à l'examen des figures annexées parmi lesquelles :

— la figure 1 illustre un exemple de transducteur piézoélectrique ;

— la figure 2 représente un exemple de montage d'un transducteur selon l'art connu ;

— la figure 3 représente un autre exemple de montage selon l'art connu ;

— la figure 4 représente un exemple de réalisation de film piézoélectrique selon l'invention ;

— la figure 5 représente un circuit permettant de polariser le film piézoélectrique selon un seul sens de polarisation ;

— les figures 6 et 7 représentent des circuits permettant de polariser le film piézoélectrique selon deux sens de polarisation opposés ;

— la figure 8 représente un exemple de capteur de pression de type connu ;

— la figure 9 représente un exemple de réalisation d'un capteur de pression selon l'invention utilisant un film polarisé selon un seuil de polarisation ;

— les figures 10 et 11 représentent des exemples de réalisation du capteur de pression selon l'invention utilisant des films polarisés selon deux sens de polarisation opposés ;

— la figure 12 représente une variante d'un exemple de réalisation d'un transducteur selon l'invention.

Comme cela a été décrit précédemment en relation avec la figure 1, un matériau piézoélectrique 1 présente un coefficient piézoélectrique $d_{3h}$ hydrostatique pouvant se décomposer en trois coefficients selon les directions 1, 2 et 3, définies par un trièdre de référence, tels que :

$$d_{3h} = d_{31} + d_{32} + d_{33}$$

Pour avoir un effet piézoélectrique hydrostatique important dans le cas de mesure d'une force de pression on a intérêt de réduire les effets piézoélectriques $d_{31}$ et $d_{32}$ car ils sont de signes contraires à $d_{33}$ et pour celà on doit réduire l'influence des composantes correspondantes du coefficient piézoélectrique $d_{3h}$.

Pour homogénéiser les contraintes, on peut envisager de prendre le film en sandwich entre deux supports rigides, ce qui implique encore le montage et qui présente un inconvénient supplémentaire en introduisant une rupture d'impédance.

En se reportant à la figure 4, on va donc décrire un transducteur selon l'invention permettant de pallier les inconvénients précédents.

Selon l'invention, on prévoit dans la masse d'un film 10 en matériau piézoélectrique, un matériau rigide 12 interdisant toute déformation du matériau piézoélectrique selon des directions parallèles au plan du film. Ce matériau peut être une pièce poreuse ou perforée. De cette façon le matériau renforçant est réellement inclus dans le polymère.

Selon un exemple de réalisation représenté en figure 4, le matériau rigide 12 est constitué de fibres 13. Ces fibres sont soit tressées entre elles, soit soudées à chacune de leur point de croisement, pour former un treilli ou une toile. Ce treillis 12 est mis à plat et est surmoulé à l'aide de matériau piézoélectrique 10, de telle façon que chacune des fibres soit enrobée dans le matériau piézoélectrique. Le treillis 12 et le matériau piézoélectrique forment un tout et il s'avère que le film ainsi obtenu ne donne lieu à un effet piézoélectrique que très faible pour toute force de compression ou d'extension s'exerçant selon le plan du film. Dans ces conditions, l'effet piézoélectrique dû aux forces de pression normales au plan du film est prépondérant. En effet, le renforcement transversal du matériau piézoélectrique vise à bénéficier de la diminution de l'effet des coefficients $d_{31}$ et $d_{32}$ dans la formule $d_{3h} = d_{31} + d_{32} + d_{33}$. La mesure de cet effet piézoélectrique par la mesure de la différence de potentiel existant entre les deux faces principales du film permet de traduire plus aisément la valeur de la force de pression exercée.

L'exemple de réalisation qui vient d'être décrit (renforcement transversal du film) convient plus particulièrement aux applications de mesures acoustiques sous-marines. Dans d'autres applications, il est possible de prévoir d'autres directions de renforcement. Le matériau piézoélectrique pourra donc être renforcé dans les directions 1, 2 ou 3, ou bien 1 et 2, 2 et 3, ou 1 et 3, ou selon des directions différentes de 1 et 2 et 3.

Selon un exemple de réalisation, le matériau piézoélectrique utilisé peut être un copolymère semi-cristallin, tel que le polyfluorure de vinylidène ($PVF_2$) ou un copolymère obtenu par association de ce copolymère avec, par exemple, du polytétrafluorure éthylène (PTFE).

Le matériau renforçant peut être conducteur ou isolant. Dans le cas d'un matériau conducteur on peut envisager un grillage métallique. Dans le cas d'un matériau isolant, un tissu de fibres de verre, de Kevlar ou de fibres de polymères conviendra.

Dans le cas de l'utilisation du copolymère $PVF_2$PTrFE, le tissu est inclus dans le polymère à la fusion lors de la formation du film composite.

Dans l'exemple des matériaux pour les applications d'acoustique sous-marine, on obtient un

3

matériau composite de faible densité qui présente une bonne adaptation d'impédance à l'eau.

Des mesures effectuées sur de tels matériaux ont donné les résultats suivants :

— un film de copolymère PVF$_2$PTrFE tel que mentionné précédemment à 60 % de polyfluorure de vinylidène (PVF$_2$) et 40 % de polytrifluoro éthylène (PTrFE), d'épaisseur de 1,6 mm, ne contenant pas de matériau renforçant, et polarisé à 80° centésimaux à l'aide d'un champ électrique de 130 kV/cm possède :

$$\text{une permittivité électrique } \varepsilon_r = 12$$
$$\text{un coefficient piézoélectrique hydrostatique}$$
$$d_{3h} = 4 \text{ pC/N (pico-Coulomb par Newton) ;}$$

— un film de même composition de même épaisseur polarisé dans les mêmes conditions que précédemment dans lequel on a incorporé un tissu de polyester présente les caractéristiques :

$$\varepsilon_r = 9$$
$$d_{3h} = 11 \text{ pC/N}$$

— un film de copolymère PVF$_2$PTrFE à 67 % de PVF$_2$ et 33 % de PTrFE, d'épaisseur 1 mm, ne contenant pas de matériau renforçant et polarisé à 80° centésimaux à l'aide d'un champ électrique de 190 kV/cm présente les caractéristiques :

$$\varepsilon_r = 10,6$$
$$d_{3h} = 4 \text{ pC/N}$$

— un film de PVF$_2$PTrFE à 67 % de PVF$_2$ et 33 % de PTrFE de mêmes dimensions, mais comprenant un tissu polyester présente les caractéristiques :

$$\varepsilon_r = 10$$
$$d_{3h} = 9 \text{ pC/N}$$

Dans les deux cas précédents où on a prévu un tissu renforçant dans la structure du film, on a obtenu une forte augmentation de $d_{3h}$, ainsi qu'une diminution de la constante diélectrique.

Si on utilise le matériau en capteur hydrostatique, c'est le coefficient gh = $d_{3h}/\varepsilon_r$ qui mesure les performances du matériau. La structure proposée est alors très performante. Le facteur de mérite $g_h d_h$ d'un hydrophone basse fréquence se trouve lui-même amélioré, d'un facteur 10 dans le cas du polymère PVF$_2$/PTrFE60 + 40 et d'un facteur 5 dans le cas de la composition 67/33.

On voit donc que la structure du transducteur piézoélectrique de l'invention permet de mesurer avec plus de sensibilité une force de pression hydrostatique, et surtout d'améliorer le rapport signal/bruit du système de détection.

Il est à noter que le matériau piézoélectrique peut être polarisé électriquement avant ou après l'inclusion du matériau renforçant. La polarisation électrique peut se faire de différentes façons.

Dans le cas où le matériau est polarisé avant inclusion du renforçateur, on prévoit le collage de deux films prenant en sandwich le matériau renforçant. Les colles sont du type époxyde ; il est alors avantageux d'enrober le matériau renforçant de polymère PVF$_2$ par trempage dans une solution de PVF$_2$ et de solvant Diméthyl Formamide par exemple. Une autre possibilité offerte par le collage est l'utilisation de matériaux renforçants basses températures type Kevlar, puisque le collage se fait à température voisine de la température ambiante.

Par exemple, les deux faces 4 et 5 du film 10 sont revêtues de dépôts métalliques 14 et 15 constituant deux électrodes.

Selon une première méthode représentée en figure 5, on soumet le film 10 à un champ électrique à l'aide d'un générateur d'alimentation électrique HT 16 connecté aux électrodes 14 et 15, et cela que le matériau renforçant 12 soit conducteur ou isolant. Le matériau piézoélectrique est polarisé selon un sens de polarisation indiqué, par exemple, par des flèches sur la figure 5.

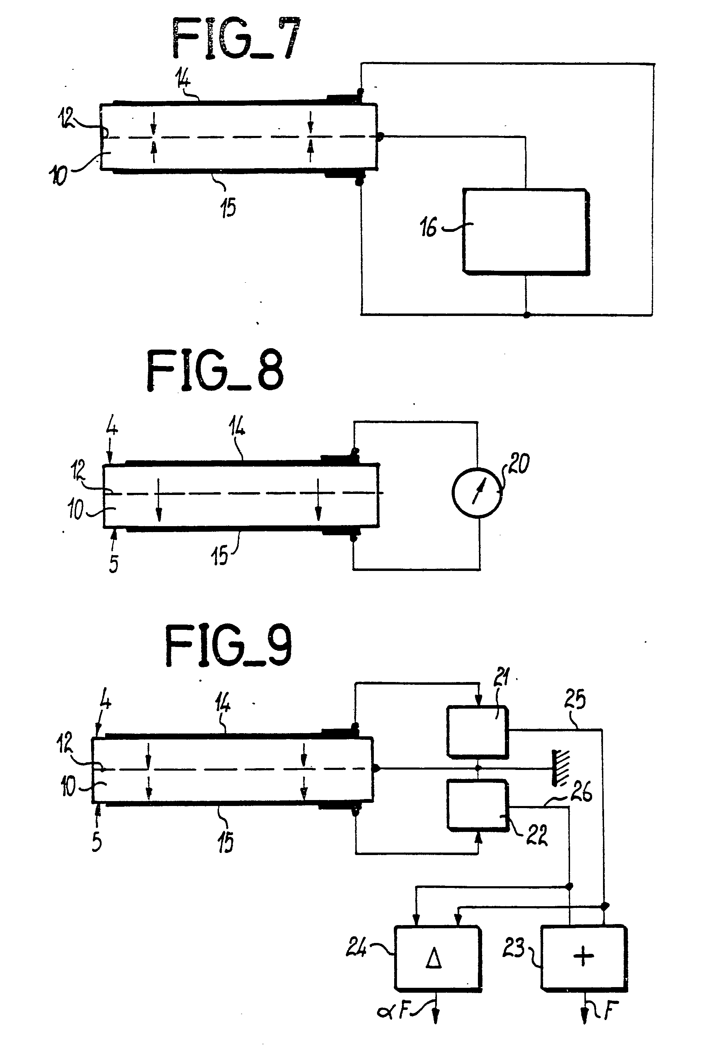

Selon une deuxième méthode, représentée en figure 6, le matériau renforçant est conducteur. Il s'agit par exemple d'une grille métallique 12. Cette grille 12 est utilisée alors comme électrode. On connecte un premier générateur électrique 17 entre la première électrode 14 et la grille 12 et un deuxième générateur électrique 18, convenablement polarisé par rapport au premier générateur, entre la grille 12 et la deuxième électrode 15.

Les deux parties du film 10 situées de part et d'autre de la grille 12 sont soumises à des champs électriques inverses qui les polarisent en sens opposés. Cela est indiqué sur la figure 6 par des flèches en opposition.

Cette deuxième méthode peut être mise en œuvre avec un seul générateur électrique 16, comme représenté en figure 7. Une borne de sortie du générateur 16 est alors connectée à la grille métallique 12 et l'autre borne de sortie du générateur 16 est connectée aux deux électrodes 14 et 15.

Le matériau piézoélectrique du film 10 étant polarisé, on dispose d'un transducteur piézoélectrique qui peut être utilisé par exemple dans un capteur de pression.

**0 168 313**

Il est à noter que dans ce qui précède, le film a été polarisé selon une direction perpendiculaire au plan du film, mais il est bien évident qu'il est possible de choisir une autre direction, par exemple dans le plan du film en prévoyant des électrodes interdigitées sur une face du film.

Selon un montage connu représenté en figure 8, on connecte, aux électrodes 14 et 15 d'un film polarisé comme décrit en relation avec la figure 5, un appareil de mesure de tension 20. Des forces de pression hydrostatique appliquées sur le film 10 et donnant lieu, par effet piézoélectrique, à la création d'une différence de potentiel entre les deux faces, seront mesurées par la valeur de tension détectée par l'appareil de mesure 20. On trouve là l'utilisation courante d'un transducteur piézoélectrique.

L'invention fournit une application du transducteur décrit précédemment, dans un capteur de forces permettant de mesurer au choix une force de pression ou un gradient de force de pression.

Le transducteur utilisé sera un transducteur comportant une grille métallique 12. Cette grille 12 délimite dans le film 10, deux domaines de polarisation. On considère tout d'abord que les sens de polarisation de ces deux domaines sont de même sens ainsi que représenté sur le film de la figure 5.

Selon l'invention, on connecte un premier dispositif de mesure de tension 21 entre l'électrode 14 et la grille métallique 12 ainsi qu'un deuxième dispositif de mesure de tension 22 entre l'électrode 15 et la grille 12. A titre d'exemple, sur la figure 9, la grille 12, c'est-à-dire le point commun des deux dispositifs 21 et 22, est connectée au potentiel zéro.

Lorsqu'une force de pression est appliquée sur le film 10, une tension est créée par effet piézoélectrique entre l'électrode 14 et la grille 12 d'une part, et entre l'électrode 15 et la grille 12 d'autre part. Les dispositifs de mesure de tension 21 et 22 mesurent les tensions créées et fournissent chacune sur leur sortie 25 et 26 un signal de mesure représentant une force de pression détectée. Les sorties 25 et 26 sont connectées aux entrées d'un additionneur 23 et d'un soustracteur 24.

L'additionneur 23 effectue la somme des résultats de mesure reçus sur ses entrées et fournit sur une sortie F un signal représentant la force de pression exercée sur le film 10.

Le soustracteur 24 effectue la différence des résultats de mesure reçus sur ses entrées et fournit sur une sortie dF un signal représentant la valeur d'un gradient de pression détecté entre les deux faces 4 et 5 du film 10.

Le capteur de l'invention permet donc de faire au choix des mesures de pression ou des mesures de gradient de pression.

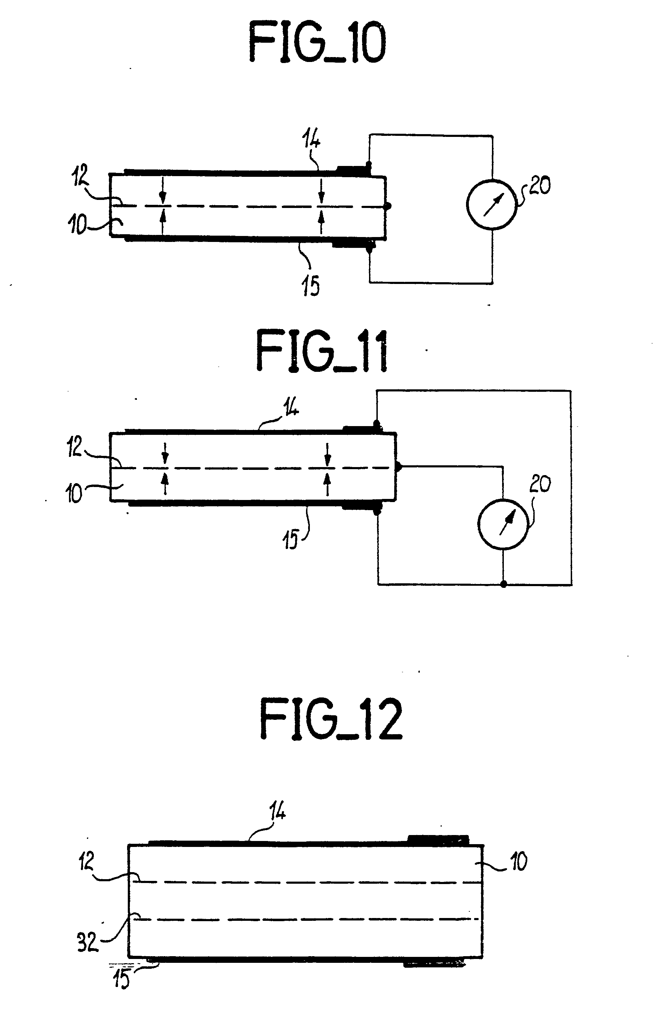

En se reportant aux figures 10 et 11, on va maintenant décrire des variantes de capteurs de l'invention utilisant un film polarisé comme représenté en figure 6, c'est-à-dire comportant deux domaines polarisés en sens inverses de part et d'autre de la grille 12.

Il convient tout d'abord de noter qu'un tel film peut être utilisé dans un capteur tel que celui de la figure 9 en tenant compte pour la connexion des dispositifs de mesure 21 et 22, des sens de polarisation.

Plus simplement, il peut être utilisé en gradientmètre de pression comme représenté sur la figure 10.

Sur la figure 10, un appareil de mesure de tension 20 est connecté aux électrodes 14 et 15. En raison des sens de polarisation inverse, le film 10 soumis à une pression permettra donc de fournir sur l'appareil de mesure 20 convenablement gradué, une valeur de gradient de pression.

De façon analogue au gradientmètre de pression de la figure 10, le capteur de la figure 11 est monté en appareil de mesure de force de pression. L'appareil de mesure de tension 20 est alors connecté, par une de ses bornes d'entrée aux électrodes 14 et 15. Dans ces conditions, les sens de polarisation inverses de deux domaines du film 10 font que l'appareil de mesure 20 mesure une valeur de force de pression.

Un intérêt du capteur de pression de la figure 11 réside dans le fait qu'il présente une capacité sensiblement quatre fois plus grande que la capacité réelle mesurée entre les deux électrodes 14 et 15. En effet, si on désigne par :

— e : l'épaisseur totale du film piézoélectrique 10,
— S : la surface du film 10 utilisée dans le capteur,
— $\varepsilon$ : la constante diélectrique,

la valeur réelle de la capacité entre les électrodes 14 et 15 est :

$$C = \varepsilon S/e$$

En supposant la grille 12 située au milieu de l'épaisseur du film 10, la valeur des capacités $C_1$ et $C_2$ mesurées entre l'électrode 14 et la grille 12, et entre l'électrode 15 et la grille 12, a pour valeur

$$C_1 = C_2 = 2\varepsilon S/e$$

Le montage de la figure 11 fournira donc pour l'appareil de mesure de tension 20, une capacité de valeur :

$$C_1 + C_2 = 4\varepsilon S/e$$

Pour l'utilisation du capteur ainsi décrit en gradientmètre, on préférera un film dans lequel la grille 12 est sensiblement dans l'épaisseur du film à égale distance des deux faces 14 et 15. Mais cela n'est pas impératif. Il convient surtout de posséder dans l'épaisseur du film, deux domaines d'importances suffisantes et développant des effets piézoélectriques mesurables, et d'étalonner les deux branches de mesure déterminées par ces deux domaines, voire de les équilibrer à l'aide d'impédances.

Par ailleurs, le capteur de l'invention peut être également utilisé pour mesurer des forces de flexion et comprendre alors de préférence un transducteur à sens de polarisation inverses.

Selon une variante de l'invention, le transducteur comporte plusieurs grilles parallèles. C'est ainsi que sur la figure 12, on a représenté un transducteur comportant deux grilles 12 et 32 parallèles et noyées dans le matériau piézoélectrique 10. Ces grilles délimitent ainsi plusieurs couches de matériau piézoélectrique. Dans le cas d'une réalisation du transducteur par collage les différentes couches peuvent être en matériaux de natures différentes.

Il est à noter que le matériau piézoélectrique utilisable peut être un composite polymère-céramique piézoélectrique, tel qu'un matériau réalisé à partir d'une suspension de poudre piézoélectrique minérale dans un polymère qui n'a pas besoin alors d'être étiré mécaniquement pour être piézoélectrique.

Enfin, il convient de préciser que les modes de réalisation de l'invention ne se limitent pas à des transducteurs de forme plane. En effet, l'invention est également applicable à un transducteur en forme de coque développable (tel qu'un tube ou un cône) ou de coque non développable (telle qu'une calotte sphérique par exemple).

## Revendications

1. Transducteur piézoélectrique comportant un film (10) en matériau piézoélectrique polarisé, comportant également au moins un matériau renforçant (12), incorporé dans la masse du film parallèlement aux faces principales (4, 5) du film (10), contrariant ainsi la déformation du film selon les directions parallèles à ces faces principales, caractérisé en ce qu'il comporte plusieurs matériaux renforçants (12, 32) disposés parallèlement et situés dans l'épaisseur du matériau piézoélectrique (10).

2. Transducteur piézoélectrique selon la revendication 1, caractérisé en ce qu'il comporte plusieurs couches de matériaux piézoélectriques de natures différentes et séparées par des matériaux renforçants.

3. Transducteur piézoélectrique selon l'une des revendications 1 ou 2, caractérisé en ce que le film (10) est polarisé perpendiculairement aux deux faces principales (4, 5) du film (10) et qu'il comporte sur ses faces principales (4, 5) une première et une deuxième électrodes (14, 15).

4. Capteur de pression utilisant le transducteur piézoélectrique selon l'une des revendications précédentes, caractérisé en ce qu'il comprend :

un premier moyen de mesure de tension (21) connecté à la première électrode (14) et au matériau renforçant (12) ;

un deuxième moyen de mesure de tension (22) connecté à la deuxième électrode (15) et au matériau renforçant (12) ;

un dispositif additionneur (23) connecté aux deux moyens de mesure de tension (21, 22) effectuant la somme des résultats de mesure effectuées par le premier et le deuxième moyens de mesure et fournissant un signal représentant une valeur de pression exercée dans le matériau piézoélectrique (10) ;

un dispositif soustracteur (24) connecté aux deux moyens de mesure de tension (21, 22) effectuant la différence des résultats de mesures effectuées par le premier et le deuxième moyens de mesure et fournissant un signal représentant une valeur de gradient de pression développé dans le matériau piézoélectrique (10).

5. Capteur de pression utilisant le transducteur piézoélectrique selon l'une des revendications précédentes, caractérisé en ce qu'il comporte :

un premier moyen de polarisation (17) connecté entre la première électrode (14) et le matériau renforçant (12) et permettant de polariser le matériau piézoélectrique, situé entre la première électrode (14) et le matériau renforçant (12), selon un premier sens de polarisation ;

un deuxième moyen de polarisation (18) connecté entre la deuxième électrode (15) et le matériau renforçant (12) et permettant de polariser le matériau piézoélectrique, situé entre la deuxième électrode (15) et le matériau renforçant (12), selon un deuxième sens de polarisation opposé au premier sens de polarisation.

6. Capteur de pression selon la revendication 4, caractérisé en ce qu'il comprend un appareil de mesure de tension (20) connecté à la première et à la deuxième électrodes et fournissant ainsi un résultat de mesure représentant un gradient de pression développé dans le matériau piézoélectrique (10).

7. Capteur de pression selon la revendication 4, caractérisé en ce qu'il comprend un appareil de mesure de tension (20) connecté, d'une part, en commun à la première et deuxième électrodes (14, 15), et d'autre part, au matériau renforçant (12), et fournissant ainsi un résultat de mesure représentant la valeur d'une pression exercée dans le matériau piézoélectrique (10).

## Claims

1. A piezoelectric transducer comprising a film (10) made of a polarized piezoelectric material and further comprising at least one reinforcing material (12) incorporated in the mass of the film in parallel to the main surfaces (4, 5) of the film (10), thus reducing the deformation of the film in directions which are parallel to said main surfaces, characterized in that it includes a plurality of reinforcing materials (12, 32) disposed in parallel and located in the thickness of the piezoelectric material (10).

2. A piezoelectric transducer according to claim 1, characterized in that it includes several layers of piezoelectric materials of different nature and separated by reinforcing materials.

3. A piezoelectric transducer according to one of claims 1 or 2, characterized in that the film (10) is polarized perpendicularly to the two main surfaces (4, 5) of the film (10) and that it comprises a first and a second electrode (14, 15) on its two main surfaces (4, 5).

4. A pressure sensor using the piezoelectric transducer according to one of the preceding claims, characterized in that it comprises :
— a first voltage measuring means (21) connected tot he first electrode (14) and to the reinforcing material (12) ;
— a second voltage measuring means (22) connected to the second electrode (15) and to the reinforcing material (12) ;
— an adder device (23) connected to both voltage measuring means (21, 22) and conceived to add the measuring results obtained by the two measuring means and to supply a signal which represents the pressure exerted in the piezoelectric material (10) ;
— a subtracting device (24) connected to both voltage measuring means (21, 22) and conceived to calculate the difference between the measuring results of both measuring means and to supply a signal which represents the pressure gradient developped in the piezoelectric material (10).

5. A pressure sensor using the piezoelectric transducer according to one of the preceding claims, characterized in that it comprises :
— a first polarisation means (17) interconnected between the first electrode (14) and the reinforcing material (12) and allowing the piezoelectric material which is located between the first electrode (14) and the reinforcing material (12) to become polarized along a first polarisation direction ;
— a second polarisation means (18) interconnected between the second electrode (15) and the reinforcing material (12) and allowing the piezoelectric material (12) which is located between the second electrode (15) and the reinforcing material (12) to become polarized along a second polarisation direction which is opposed to the first one.

6. A pressure sensor according to claim 4, characterized in that it comprises a voltage measuring apparatus (20) connected to the first and to the second electrode and thus supplying a measuring result representing a pressure gradient developped in the piezoelectric material (10).

7. A pressure sensor according to claim 4, characterized in that it comprises a voltage measuring apparatus (20) connected on the one side in common to the first and to the second electrode (14, 15) and on the other side to the reinforcing material (12), thus supplying a measuring result which represents the pressure exerted in the piezoelectric material (10).


**Patentansprüche**

1. Piezoelektrischer Wandler mit einer Schicht (10) aus polarisiertem, piezoelektrischem Material und außerdem mit einem Verstärkungsmaterial (12), das in die Masse der Schicht parallel zu den Hauptoberflächen (4, 5) der Schicht (10) eingebettet ist und so der Verformung der Schicht in Richtungen parallel zu diesen Hauptoberflächen entgegenwirkt, dadurch gekennzeichnet, daß er mehrere Verstärkungsmaterialien (12, 32) aufweist, die parallel zueinander und in der Dicke des piezoelektrischen Materials (10) liegen.

2. Piezoelektrischer Wandler nach Anspruch 1, dadurch gekennzeichnet, daß er mehrere Schichten piezoelektrischen Materials unterschiedlicher Art besitzt, die durch Verstärkungsmaterialien voneinander getrennt sind.

3. Piezoelektrischer Wandler nach einem der Ansprüche 1 oder 2, dadurch gekennzeichnet, daß die Schicht (10) senkrecht zu den beiden Hauptoberflächen (4, 5) der Schicht (10) polarisiert ist und daß er auf seinen Hauptoberflächen eine erste und eine zweite Elektrode (14, 15) trägt.

4. Druckmeßsonde, die einen piezoelektrischen Wandler nach einem der vorhergehenden Ansprüche verwendet, dadurch gekennzeichnet, daß sie aufweist :
— ein erstes Mittel zu Spannungsmessung (21), das an die erste Elektrode (14) und an das Verstärkungsmittel (12) angeschlossen ist :
— ein zweites Mittel zur Spannungsmessung (22), das an die zweite Elektrode (15) und an das Verstärkungsmaterial (12) angeschlossen ist :
— eine Addiervorrichtung (23), die mit den beiden Spannungsmeßmitteln (21, 22) verbunden ist und die Summe aus den Meßergebnissen der ersten und zweiten Meßmittel bildet sowie ein Signal liefert, das ein Maß für den im piezoelektrischen Material (10) wirksamen Druck ist :
— eine Subtraktionsvorrichtung (24), die mit den beiden Spannungsmeßmiteln (21, 22) verbunden ist und die Differenz aus den Meßergebnissen der beiden Meßmittel bildet sowie ein Signal liefert, das ein Maß für den im piezoelektrischen Material (10) wirksamen Druckgradienten ist.

5. Druckmeßsonde, die den piezoelektrischen Wandler nach einem der vorhergehenden Ansprüche verwendet, dadurch gekennzeichnet, daß sie aufweist :
— ein erstes Polarisationsmittel (17), das zwischen der ersten Elektrode (14) und dem Verstärkungsmaterial (12) angeschlossen ist und das zwischen der ersten Elektrode (14) und dem Verstärkungsmaterial (14) liegende piezoelektrische Material gemäß einer ersten Polarisationsrichtung zu polarisieren erlaubt ;
— ein zweites Polarisationsmittel (18), das zwischen der zweiten Elektrode (15) und dem Verstärkungsmaterial (12) angeschlossen ist und das zwischen der zweiten Elektrode (15) und dem Verstärkungsmaterial (12) liegende piezoelektrische Material gemäß einer zweiten zur ersten entgegengesetzten Polarisationsrichtung zu polarisieren erlaubt.

6. Druckmeßsonde nach Anspruch 4, dadurch gekennzeichnet, daß sie ein Spannungsmeßgerät (20) aufweist, das an die erste und die zweite Elektrode angeschlossen ist und so ein Meßergebnis liefert, das ein Maß für den im piezoelektrischen Material wirksamen Druckgradienten ist.

7. Druckmeßsonde nach Anspruch 4, dadurch gekennzeichnet, daß sie ein Spannungsmeßgerät (20) aufweist, das einerseits gemeinsam an die erste und an die zweite Elektrode (14, 15) und andrerseits an das Verstärkungsmaterial (12) angeschlossen ist und ein Meßergebnis liefert, das ein Maß für den auf das piezoelektrische Material (10) ausgeübten Druck ist.

# FIG_1

# FIG_2

# FIG_3

# FIG_4

# FIG_5

# FIG_6

FIG_7

FIG_8

FIG_9

# FIG_10

# FIG_11

# FIG_12